# DEMANDE DE BREVET EUROPEEN

(11) **EP 3 255 691 A1**
(43) Date de publication de la demande: **13.12.2017**
(21) Numéro de dépôt: 17175300.7
(22) Date de dépôt: 09.06.2017
(51) Int. Cl.: H01L 51/00

(54) **MODULE LUMINEUX À DIODE ÉLECTROLUMINESCENTE ORGANIQUE FLEXIBLE**

(30) Priorité: 10.06.2016 FR 1655331
(71) Demandeur: Valeo Vision, 93012 Bobigny Cedex (FR)
(72) Inventeur: JAGANATHEN, Camille, 93012 BOBIGNY CEDEX (FR)

(57) **Abrégé**

Diode électroluminescente organique flexible (6) caractérisée en ce qu'elle comprend au moins une partie courbée (18) dont au moins une portion (20) est recouverte par une couche de vernis.

## Description

L'invention relève du domaine des dispositifs d'éclairage et/ou de signalisation, intérieur et/ou extérieur, pour véhicule automobile, et elle concerne plus particulièrement les modules lumineux comportant des diodes électroluminescentes organiques flexibles.

L'invention a pour objet une diode électroluminescente organique courbée. Elle a aussi pour objet le module lumineux comprenant la diode électroluminescente organique courbée. Et enfin l'invention porte également sur le procédé de mise en forme de diode électroluminescente organique.

Une diode électroluminescente organique, connu notamment par son acronyme anglo-saxon OLED pour « Organic Light-Emitting Diode », est classiquement composée d'un substrat sur lequel est disposé un ensemble émetteur formé de deux électrodes (une anode et une cathode) entre lesquelles est placée au moins une couche d'émission, réalisée dans un matériau électroluminescent organique. L'excitation, par application d'une tension électrique entre les deux électrodes, de la couche d'émission permet l'émission de rayons lumineux à travers le substrat en sortie de la diode.

Les diodes électroluminescentes organiques sont de plus en plus utilisées dans le domaine automobile, tant pour la réalisation de fonction d'éclairage ou de signalisation du véhicule à proprement parler, que pour des fonctions esthétiques, et notamment de signature visuelle et lumineuse du véhicule en produisant des styles d'éclairage et/ou de signalisation tridimensionnels. Dans cette application pour des véhicules automobiles, il est connu d'agencer les diodes électroluminescentes organiques avec une partie émettrice, disposée généralement en regard d'une glace de fermeture d'un projecteur, et une partie de connexion par laquelle ce module lumineux est connecté à un dispositif d'alimentation électrique et de pilotage du dispositif d'éclairage et/ou de signalisation du véhicule.

Les diodes électroluminescentes organiques utilisées dans les projecteurs de véhicules automobiles peuvent consister en des diodes électroluminescentes organiques rigides, avec un substrat en verre, ou en des diodes électroluminescentes organiques flexibles, c'est-à-dire qui peuvent prendre un galbe et ne plus s'étendre uniquement dans un plan, avec un substrat en matière plastique.

L'utilisation d'une diode électroluminescente organique flexible présente l'avantage de pouvoir être plié ou roulé aisément et offre ainsi des possibilités accrues pour la réalisation d'un style propre au véhicule sur lequel ces sources de lumière spécifiques sont appliquées.

Toutefois, l'intégration de ces diodes électroluminescentes organiques flexibles dans les modules d'éclairage est difficile car il est compliqué de les conformer à une forme définie préalablement sans impacter leurs performance d'éclairage, finesse et aspect esthétique. Or, cette conformation de la diode électroluminescente organique flexible est nécessaire au moins pour assurer la stabilité de la forme de la source de lumière dans le temps et donc la constance de la fonction d'éclairage.

La présente invention a pour objectif de résoudre les inconvénients décrits ci-dessus en concevant une diode électroluminescente organique flexible pouvant être facilement conformée pour produire un style d'éclairage et/ou de signalisation tridimensionnel.

Selon l'invention, une diode électroluminescente organique flexible est caractérisée en ce qu'elle comprend au moins une partie courbée dont au moins une portion est recouverte par une couche de vernis.

Par au moins une portion recouverte de vernis, on entend couvrir aussi bien le fait que la diode électroluminescente organique flexible peut présenter une couche de vernis réalisée ponctuellement sur une unique zone de la diode ou bien sur plusieurs zones, et que pour chacune de ces zones, la couche de vernis peut être appliquée sur l'une ou l'autre des faces de la diode.

On utilise le vernis pour faciliter la tenue dans le temps de la déformation de la diode électroluminescente organique flexible lorsque celle-ci est dans une deuxième forme comprenant une partie courbée supplémentaire par rapport à une première forme ou forme initiale de la diode électroluminescente organique flexible.

Selon une caractéristique de l'invention, la couche de vernis recouvrant la portion peut présenter une épaisseur variable en fonction du rayon de courbure de la partie courbée. Dans ce cas, l'épaisseur de la couche de vernis peut dépendre du rayon de courbure de la partie courbée de la diode électroluminescente organique flexible en un point donné.

Selon un aspect de l'invention, l'épaisseur de la couche de vernis est d'autant plus grande que le rayon de courbure de la partie courbée est petit. En d'autres termes, l'épaisseur de la couche de vernis en un point donné de ladite au moins partie courbée de la diode électroluminescente organique flexible est d'autant plus grande que le rayon de courbure de ladite au moins une partie courbée de la diode électroluminescente organique flexible en ce point donné lorsque la diode électroluminescente est dans la deuxième forme, est petit.

Que le vernis soit déposé de façon homogène ou discontinue, on peut prévoir que l'épaisseur de couche de vernis est inférieure ou égale à l'épaisseur de la diode électroluminescente organique flexible.

Indépendamment de l'exemple de réalisation choisi, l'invention possède au moins l'une des caractéristiques suivantes, considérées isolément ou en combinaison :
- la portion recouverte par une couche de vernis est une portion émettrice de lumière, et notamment dans ce cas, le vernis est transparent ou translucide ;
- la portion recouverte par une couche de vernis est une portion non émettrice de lumière, et notamment dans ce cas, le vernis est opaque ;
- le vernis est photosensible et/ou thermosensible ;
- la diode électroluminescente organique flexible est en forme de feuille comprenant une face émettrice et une face non-émettrice ; et dans ce cas, on peut prévoir que le vernis ne soit déposée que sur la face non-émettrice ;
- la diode électroluminescente organique flexible comprend au moins un partie de connexion électrique et/ou au moins une partie de maintien mécanique ;
- la partie de connexion électrique et la partie de maintien mécanique ont une localisation commune sur la diode électroluminescente flexible ;
- la partie de connexion électrique est formée d'un ou de plusieurs éléments de connexion ;
- la partie de maintien est formée d'un ou de plusieurs éléments de maintien.

L'invention concerne également un module lumineux comprenant au moins une diode électroluminescente organique flexible telle qu'elle vient d'être précisée.

On pourra notamment prévoir que le module lumineux comporte un support de diode, et que la diode électroluminescente organique flexible est maintenue sur ce support par un ou deux de ses bords. Avantageusement, la diode électroluminescente organique flexible est maintenue sur ce support uniquement au niveau du ou desdits deux bords.

Le cas échéant, le module lumineux comporte une glace de fermeture à travers laquelle au moins une fraction de la diode électroluminescente organique flexible est visible, la portion de la partie courbée recouverte par la couche de vernis s'étendant uniquement au niveau de cette fraction visible de la diode électroluminescente organique flexible. On pourra dans ce cas prévoir que la portion de la partie courbée recouverte par la couche de vernis est dépourvue d'élément de connexion électrique de la diode électroluminescente organique flexible et/ou d'élément de maintien mécanique de la diode électroluminescente organique flexible.

Avantageusement, le module lumineux est agencé en module lumineux d'un véhicule automobile, notamment en un dispositif d'éclairage ou de signalisation ou d'éclairage de l'intérieur d'un véhicule automobile. Le cas échéant, la diode électroluminescente organique flexible est apte à participer à toute ou partie d'une fonction d'éclairage, de signalisation ou d'éclairage de l'intérieur du véhicule automobile.

L'invention concerne en outre un procédé de mise en forme d'une diode électroluminescente organique flexible, notamment d'une diode électroluminescente organique flexible telle qu'elle vient d'être présentée.

Le procédé comprend une première étape consistant à fournir une diode électroluminescente organique flexible, une deuxième étape de traitement comprenant au moins une étape d'application d'un vernis sur au moins une portion de la diode électroluminescente organique flexible et une troisième étape de rigidification consistant à rigidifier le vernis pour maintenir la diode électroluminescente organique flexible dans une forme prédéterminée.

Selon une série de caractéristiques de l'invention, prises isolément ou en combinaison, on pourra prévoir que :
- la diode électroluminescente dans la première étape présente une première forme, la troisième étape de rigidification consistant à maintenir la diode électroluminescente organique flexible dans une deuxième forme prédéterminée différente de la première forme et obtenue lors de la deuxième étape ;
- la deuxième forme présente au moins une courbe supplémentaire par rapport à la première forme ;
- la première forme de la diode électroluminescente organique flexible est une forme plate ;
- la deuxième forme est une forme plate, contenue dans un plan, et notamment dans le même plan que le plan défini par la première forme de la diode électroluminescente organique flexible ; ou bien la deuxième forme est courbée, et s'inscrit notamment dans une pluralité de plans sécants, en présentant par exemple au moins en partie une surface réglée ;
- la deuxième étape de traitement comprend en outre une étape de formage de la diode électroluminescente organique flexible selon la deuxième forme prédéterminée ; et l'on peut prévoir que cette étape de formage intervienne avant ou après l'étape d'application du vernis ;
- l'étape de formage comprend une première sous-étape de préhension de la diode électroluminescente organique flexible selon la première forme via au moins deux moyens de prise, notamment des pinces, et une sous-étape de déplacement de l'un des moyens de prise par rapport à un autre des moyens de prise pour former la diode électroluminescente organique flexible selon la deuxième forme ;
- l'étape de formage peut comprendre une sous-étape, notamment une troisième sous-étape, de protection d'au moins une partie de connexion électrique et/ou de maintien mécanique de la diode électroluminescente organique flexible, par exemple par application d'un masque sur ladite au moins une partie de connexion électrique et/ou de maintien mécanique, afin d'éviter de recouvrir cette au moins une parties par du vernis. En variante, l'étape de protection peut être simultanée à l'étape de préhension, la préhension de la diode électroluminescente organique flexible par les moyens de prise se faisant au niveau de ladite au moins une partie de connexion électrique et/ou de maintien mécanique.
- l'étape d'application du vernis est une étape d'application du vernis sur ladite au moins une portion de la diode électroluminescente organique à l'aide d'un pinceau ou d'un rouleau tampon ;
- l'étape d'application du vernis est une étape de pulvérisation de vernis sur ladite au moins portion de la diode électroluminescente organique ;
- l'étape d'application du vernis est une étape d'immersion de ladite au moins portion de la diode électroluminescente organique dans un bain de vernis ;
- l'étape d'application du vernis est une étape d'évaporation de vernis sur ladite au moins portion de la diode électroluminescente organique ;
- l'étape de rigidification du vernis est une étape de réticulation du vernis, par exemple au moyen de rayons UV, par séchage suite à une hausse de la température environnante.

D'autres caractéristiques et avantages de la présente invention apparaitront plus clairement à l'aide de la description et des dessins parmi lesquels :
- la figure 1 est une vue de face de deux diodes électroluminescentes organiques flexibles disposées sur un support commun compris dans un module lumineux selon un premier mode de réalisation de l'invention ;
- la figure 2 est une vue de face de la diode électroluminescente organique selon un deuxième mode de réalisation de l'invention ;
- la figure 3 est une vue de face de la diode électroluminescente organique selon un troisième mode de réalisation de l'invention ;
- la figure 4 représente deux logigrammes illustrant chacun un enchaînement d'étapes effectuées durant un procédé de mise en forme selon l'invention.

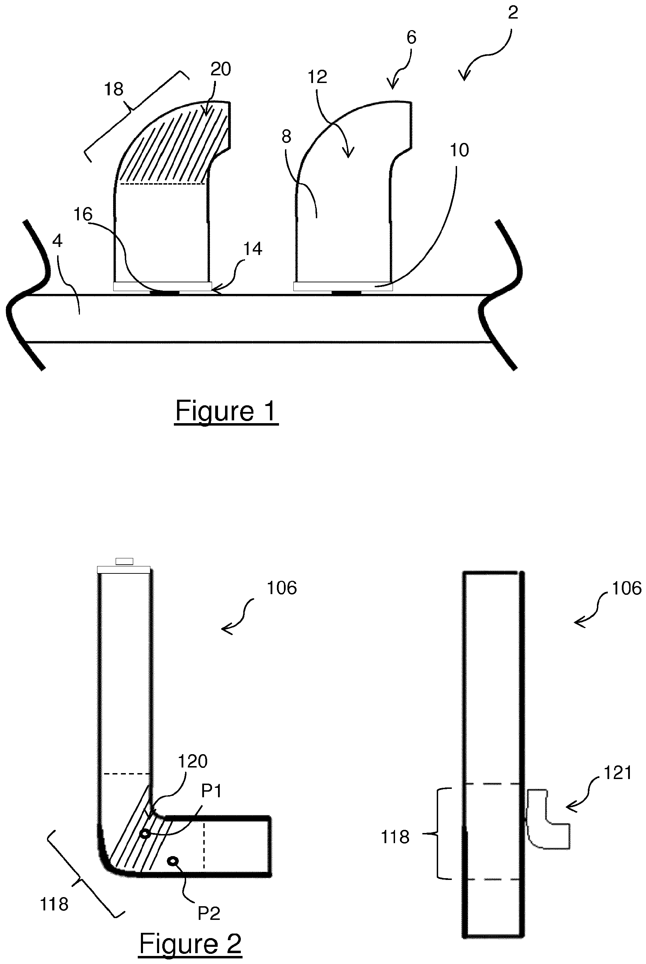

La figure 1 représente partiellement un module lumineux 2 comportant un support 4 commun à une pluralité de diodes électroluminescentes organique flexibles 6, notamment deux telles que représentées.

Ce module lumineux 2 peut être appliqué aussi bien dans un projecteur avant que dans un feu arrière de véhicule et il peut en outre être appliqué dans des dispositifs d'éclairage intérieur de l'habitacle du véhicule.

Le support commun 4 est configuré pour recevoir la ou les diodes électroluminescentes organiques flexibles 6, et pour être fixé à la structure du dispositif d'éclairage dans lequel il est implanté.

La diode électroluminescente organique flexible 6 comprend une partie émettrice 8 et une partie de connexion 10 permettant le maintien de la diode sur le support commun 4 et le raccordement électrique de la partie émettrice 8 avec un dispositif d'alimentation électrique et/ou de pilotage, ici non représenté, de l'ensemble des diodes électroluminescentes organiques flexibles 6 dans le module lumineux 2. Au moins la partie émettrice 8 est formée sur un substrat plastique permettant sa déformation et sa courbure selon une ou plusieurs directions.

La partie émettrice 8 de la diode électroluminescente organique flexible 6 est configurée en forme de feuille présentant deux faces distinctes, parmi lesquelles une première face 12, émettrice, et une deuxième face opposée 13.

On pourra prévoir que la deuxième face opposée 13 est également émettrice, ou bien que seule la première face 12 est émettrice, c'est-à-dire que les rayons lumineux émis par la diode électroluminescente organique flexible ne sortent que par cette première face 12. Par ailleurs, en variantes non représentées, on comprendra que la diode électroluminescente organique flexible pourrait, sans sortir du contexte de l'invention, prendre une forme différente de celle de feuille décrite dans le présent mode de réalisation, et qu'elle pourrait comporter plus de deux faces, parmi lesquelles une ou plusieurs faces pourraient être émettrices.

La partie de connexion 10 peut également être formée sur la base d'un substrat en matière plastique, et avantageusement le même que celui servant à la partie émettrice 8, ou bien être réalisée avec un matériau isolant, mécaniquement plus rigide, et par exemple, et de manière non limitative, du verre ou de la résine polymère. Selon le mode de réalisation plus particulièrement illustré sur les figures, elle se présente au moins sur un bord 14 de la diode électroluminescente organique flexible 6 sous la forme d'une plaque sensiblement parallélépipédique. Dans le mode de réalisation illustré, la partie émettrice 8 de la diode électroluminescente organique flexible 6 s'étend depuis un côté de la partie de connexion 10 et un connecteur 16, configuré pour coopérer avec des moyens de connexion agencés dans le support commun 4, s'étend depuis la partie de connexion 10 à l'opposé de la partie émettrice 8. Le connecteur 16 est ici configuré pour réaliser la fixation mécanique de la diode électroluminescente organique flexible 6 et la connexion électrique au réseau du véhicule. On pourra noter que la fixation mécanique de la diode électroluminescente organique se fait de manière flottante, c'est-à-dire que la diode est maintenue mécaniquement sur un seul bord, au moins deux bords étant laissés libres. Dans ce cas, les éléments formant la partie de maintien mécanique et les éléments formant la partie de connexion électrique sont tous situés sur un même bord.

La diode électroluminescente organique flexible 6 selon l'invention comprend au moins une partie courbée 18, ici ménagée à l'opposé de la partie de connexion 10. Cette partie courbée 18 comprend au moins une portion 20 recouverte d'une couche de vernis représentée schématiquement sur les figures par des hachures. La portion 20 recouverte d'une couche de vernis est, dans le mode de réalisation illustré sur la figure 1, comprise dans la partie émettrice 8 de la diode électroluminescente organique flexible 6.

Tel que cela sera décrit plus en détails ci-après, notamment dans la description du mode d'obtention de la diode électroluminescente flexible conformée selon l'invention, la couche de vernis permet de figer la conformation courbée de la diode électroluminescente organique. Pour obtenir un tel effet, on peut prévoir que la portion recouverte d'une couche de vernis s'étende aussi bien sur l'une et/ou l'autre des faces 12, 13 de la partie émettrice. Le choix d'appliquer la couche de vernis sur l'une et/ou l'autre des faces de la partie émettrice pourra notamment dépendre de la capacité d'émission de rayons lumineux de chacune de ces faces. Dans le cas où les deux faces de la partie émettrice sont émettrices, la couche de vernis pourra être indifféremment disposée sur l'une et/ou l'autre des faces. Dans le cas où seule la première face 12 est émettrice, la couche de vernis pourra avantageusement être disposée sur la deuxième face opposée 13, non émettrice.

La couche de vernis présente sur la portion 20 de la partie courbée 18 peut être d'épaisseur variable le long de cette portion 20, notamment en fonction du rayon de courbure de la partie courbée 18. En d'autres termes, l'épaisseur de la couche de vernis en un point donné de la portion 20 dépend du rayon de courbure de la partie courbée 18 en ce point. Ainsi, en se référant notamment aux exemples illustrés sur la figure 2, l'épaisseur de la couche de vernis sur la portion 20 est plus grande au voisinage du premier point P1 qu'au voisinage du deuxième point P2, le rayon de courbure de la partie courbée 18 étant plus faible au premier point P1 qu'au deuxième point P2.

L'épaisseur de la couche de vernis sur la portion 20 est inférieure à l'épaisseur de la diode électroluminescente organique flexible 6.

Le vernis est avantageusement translucide notamment lorsque la portion 20 qu'il recouvre s'étend sur la première face émettrice 12. On comprend que le vernis peut selon un autre mode de réalisation être opaque, notamment lorsque la portion 20 recouverte d'une couche de vernis s'étend sur une face non-émettrice, ou bien sur une zone d'une face émettrice 12 non configurée pour permettre l'émergence des rayons lumineux de la diode électroluminescente organique flexible 6.

Le vernis présente des propriétés photosensibles et/ou thermosensibles. Les propriétés du vernis varient suite à l'exposition à un rayonnement ultra-violet « UV » et/ou en fonction de la température. Le vernis subit notamment une réticulation sous l'action d'un catalyseur tel que la chaleur ou le rayonnement UV. Le vernis est ainsi susceptible de passer d'un premier état, dans lequel il peut facilement être appliquée sur l'une et/ou l'autre des faces de la diode électroluminescente organique flexible, à un deuxième état dans lequel il présente un effet durcisseur sur la portion 20 et notamment sur la partie courbée 18, permettant de maintenir la diode électroluminescente organique flexible 6 selon une forme prédéterminée. Selon l'invention, l'application de la couche de vernis sur la diode électroluminescente organique flexible 6 permet de conformer cette dernière selon une configuration souhaitée en la rigidifiant sans risque de détériorer la structure de la diode électroluminescente organique flexible 6.

On peut notamment prévoir que le vernis soit, par exemple, un vernis thermodurcissant GQ 20-0880 de BASF. De tels vernis sont habituellement utilisés pour corriger des défauts sur des surfaces optiques. Ce vernis peut s'appliquer en couche sur une portion de la diode électroluminescente organique flexible formée notamment de polyimide.

On a illustré sur les figures 1 et 2 deux modes de réalisation différents en la dimension de la portion 20 recouverte d'une couche de vernis. Sur la figure 1, la diode électroluminescente organique flexible 6 présente une partie courbée 18 en bout de la partie émettrice 8, et la portion 20 recouverte d'une couche de vernis s'étend sur toute la partie courbée. La diode électroluminescente organique flexible 106 de la figure 2 diffère en la localisation de la partie courbée 118 et surtout dans le fait que la portion 120 recouverte d'une couche de vernis correspond à une zone présentant une superficie inférieure à celle de la partie courbée 118, de sorte que la partie courbée est ici partiellement recouverte d'une couche de vernis. Sur la figure 2bis, on a illustré la diode électroluminescente organique flexible 106 dans sa première forme, ou forme d'origine, dans laquelle elle est plate et rectiligne, cette diode étant amenée à venir au contact d'un coin 121 contre lequel elle est enroulée pour prendre la forme courbée, dans le plan défini par la première forme de la diode, illustrée sur la figure 2. La première forme et la deuxième forme prédéterminée de la diode s'inscrivent dans un même plan, et la deuxième forme présente au moins une partie courbée supplémentaire par rapport à la première forme.

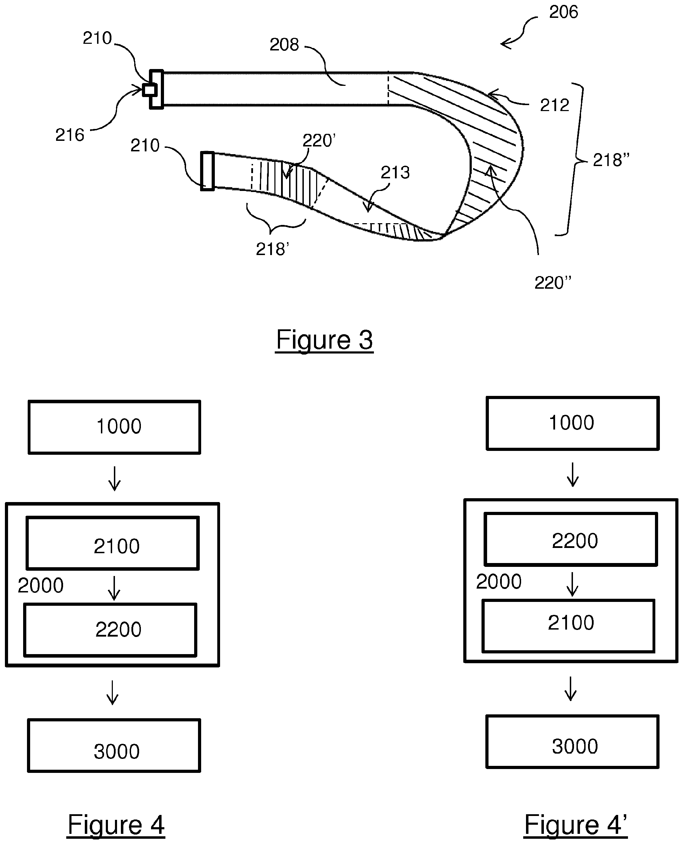

La figure 3 représente un troisième mode de réalisation de l'invention selon lequel la diode électroluminescente organique flexible 206 diffère des diodes précédemment illustrées en ce que d'une part elle ne s'étend pas dans un plan unique en prenant une forme plate, comme cela est notamment le cas de la diode 106 illustré sur la figure 2, et en ce que d'autre part elle présente deux parties courbées 218, 218'. Tel qu'illustré, la diode 206 est conformée selon un procédé de mise en forme décrit ci-après pour que la forme finale, c'est-à-dire une deuxième forme prédéterminée différente de la première forme d'origine, est courbée et s'inscrit dans une pluralité de plans sécants. La forme finale de la diode pourra être obtenue par une succession de pliages réalisés de sorte que la diode présente au moins en partie une surface réglée.

La diode électroluminescente organique flexible 206 comprend ici deux parties de connexion 210, chacune située sur un parmi deux bords d'extrémité opposés de la diode. Selon le mode de réalisation, une des deux parties de connexion 210 ou les deux parties de connexion 210 peuvent comprendre un connecteur 216 tel que défini précédemment pour fixer mécaniquement et/ou raccorder électriquement la diode électroluminescente organique flexible 206. Comme précédemment, la diode électroluminescente organique flexible 206 est maintenue de façon flottante, c'est-à-dire avec au moins deux bords libres.

La diode électroluminescente organique flexible 206 comprend une partie émettrice 208 avec deux faces émettrices 212, 213 et les deux parties courbées 218, 218' sont ménagées dans la partie émettrice Les première et la deuxième parties courbées 218', 218" présentent respectivement une première portion 220' et une deuxième portion 220" recouvertes respectivement d'une première couche de vernis et d'une deuxième couche de vernis. Le vernis appliqué sur ces parties courbées 218', 218" est transparent ou translucide autorisant le passage de rayons lumineux.

La première partie courbée 218' présente un rayon de courbure inférieur au rayon de courbure de la deuxième partie courbée 218" et conformément à ce qui a pu être décrit précédemment, l'épaisseur de la couche de vernis sur la première portion 220' est supérieure à l'épaisseur de la couche de vernis sur la deuxième portion 220".

On va maintenant décrire, en se référant notamment aux figures 4 et 4', des modes de réalisation d'un procédé de mise en forme d'une diode électroluminescente organique flexible telle qu'elle vient d'être présentée.

Le procédé de mise en forme de la diode électroluminescente organique flexible comprend une première étape 1000 de préhension d'une diode électroluminescente organique flexible, au cours de laquelle on dispose une diode flexible dans un agencement adapté pour réaliser les opérations ultérieures, puis une deuxième étape 2000 de traitement comportant une étape de formage et une étape d'application du vernis, et une troisième étape 3000 de rigidification du vernis.

On comprendra que l'on pourrait répéter l'étape d'application du vernis plusieurs fois selon le besoin en fonction de l'épaisseur de la couche de vernis souhaitée, et que ces étapes d'application de vernis supplémentaires pourraient avoir lieu avant ou après la troisième étape 3000 de rigidification.

La deuxième étape de traitement 2000 peut différer d'un premier procédé de mise en forme illustré sur la figure 4 à un deuxième procédé de mise en forme illustré sur la figure 4' en ce qu'elle consiste soit en la succession d'une étape de formage 2100 suivi d'une étape d'application du vernis 2200, soit en la succession d'une étape d'application du vernis 2200 suivi d'une étape de formage 2100.

L'un des deux procédés sera notamment préféré à l'autre en fonction des propriétés du vernis qui est appliqué, notamment le temps de rigidification.

Dans chacun des deux cas, l'étape de formage consiste à créer la deuxième forme, ou forme finale, de la diode électroluminescente flexible. Elle peut comprendre une première sous-étape de préhension de la diode électroluminescente organique flexible selon la première forme via au moins deux moyens de prise, notamment à l'aide de pinces. Cette sous-étape de préhension est suivie d'une sous-étape consistant à déplacer au moins un des moyens de prise, ou simultanément l'ensemble des moyens de prise, pour déformer la diode flexible par ce mouvement relatif les uns par rapport aux autres des bords de la diode tenus par les moyens de prise, et dans des proportions calculées pour former la diode électroluminescente organique flexible selon la deuxième forme désirée. Selon le mode de réalisation, cette étape de formage peut comprendre une troisième sous-étape dite de protection consistant à protéger une ou plusieurs parties de connexion électrique et/ou de maintien mécanique de la diode électroluminescente organique flexible. Pour ce faire, durant cette sous-étape de protection, un masque est appliqué sur lesdites parties de connexion électrique et/ou de maintien mécanique, afin d'éviter de recouvrir ces parties par du vernis, le vernis pouvant empêcher la bonne connexion et/ou le bon maintien de la diode électroluminescente. Selon un mode de réalisation, l'étape de protection peut être simultanée à l'étape de préhension, la préhension de la diode électroluminescente organique flexible par les moyens de prise se faisant alors au niveau desdites parties de connexion électrique et/ou de maintien mécanique, de sorte que les moyens de prise jouent le rôle du masque précédemment cité.

L'application 2200 du vernis sur au moins une portion de la diode électroluminescente organique flexible peut se faire selon différents modes opératoires choisis parmi la pulvérisation, l'immersion dans un bain de vernis, l'évaporation ou encore l'application à l'aide d'un pinceau, d'un tampon ou d'un rouleau.

On saura choisir l'un ou l'autre des modes opératoires notamment en fonction de la localisation de la ou des portions à recouvrir de vernis et en fonction de l'accessibilité de ces portions. A titre d'exemple, l'immersion dans un bain de vernis ne sera privilégiée que si l'intégralité de la partie émettrice doit être recouverte de vernis.

Un module de commande définit la zone de projection de vernis et l'épaisseur de la couche de vernis à projeter en fonction de la première forme sous laquelle arrive la diode électroluminescente flexible dans la première étape du procédé, avant formage et application de vernis, et en fonction de la deuxième forme prédéterminée à donner à la diode.

L'étape de rigidification du vernis 3000 est l'étape finale du procédé de mise en forme consistant en une étape de réticulation du vernis au moyen d'un catalyseur. Le vernis va ainsi se rigidifier par exemple suite à un rayonnement UV, ou à une variation de température, notamment une hausse de la température. Le temps de rigidification pourra varier en fonction de la quantité de vernis disposée dans l'étape précédente sur la portion de la partie courbée de la diode.

## Revendications

1. Diode électroluminescente organique flexible (6 ; 106 ; 206) **caractérisée en ce qu'**elle comprend au moins une partie courbée (18 ; 118 ; 218, 218') dont au moins une portion (20 ; 120 ; 220', 220") est recouverte par une couche de vernis.

2. Diode électroluminescente organique flexible selon la revendication précédente, **caractérisée en ce que** l'épaisseur de couche de vernis recouvrant la portion (20 ; 120 ; 220', 220") est variable en fonction du rayon de courbure de la partie courbée (18 ; 118 ; 218, 218').

3. Diode électroluminescente organique flexible selon l'une quelconque des revendications précédentes, **caractérisée en ce que** l'épaisseur de la couche de vernis est inférieure ou égale à l'épaisseur de la diode électroluminescente organique flexible.

4. Diode électroluminescente organique flexible selon l'une quelconque des revendications précédentes, **caractérisée en ce que** la au moins une portion (20 ; 120 ; 220', 220") recouverte d'une couche de vernis est une portion émettrice de lumière.

5. Diode électroluminescente organique flexible selon l'une quelconque des revendications précédentes, **caractérisée en ce que** le vernis est transparent ou translucide.

6. Diode électroluminescente organique flexible selon l'une quelconque des revendications précédentes, **caractérisée en ce que** la au moins une portion (20 ; 120 ; 220', 220") recouverte d'une couche de vernis est une portion non-émettrice de lumière.

7. Diode électroluminescente organique flexible selon l'une quelconque des revendications précédentes, **caractérisée en ce qu'**elle soit en forme de feuille comprenant une face émettrice (12 ; 212) et une face non-émettrice (13 ; 213).

8. Diode électroluminescente organique flexible selon la revendication précédente, **caractérisée en ce que** la portion (20 ; 120 ; 220', 220") recouverte d'une couche de vernis est une portion de la face non-émettrice (13 ; 213).

9. Module lumineux (2) comprenant au moins une diode électroluminescente organique flexible (6 ; 106 ; 206) courbée selon l'une quelconque des revendications précédentes.

10. Procédé de mise en forme d'une diode électroluminescente organique flexible comprenant une première étape (1000) consistant à fournir une diode électroluminescente organique flexible (6 ; 106 ; 206), une deuxième étape de traitement (2000) comprenant au moins une étape d'application (2200) d'un vernis sur au moins une portion (20 ; 120 ; 220', 220") de la diode électroluminescente organique flexible (6, 6') et une troisième étape (3000) de rigidification consistant à rigidifier le vernis pour maintenir la diode électroluminescente organique flexible (6 ; 106 ; 206) dans une forme prédéterminée.

11. Procédé de mise en forme selon la revendication précédente, **caractérisé en ce que** l'on fournit une diode électroluminescente organique flexible (6 ; 106 ; 206) selon une première forme dans la première étape (1000) et **en ce que** la troisième étape (3000) de rigidification consiste à maintenir la diode électroluminescente organique flexible (6 ; 106 ; 206) dans une deuxième forme prédéterminée différente de la première forme.

12. Procédé de mise en forme selon l'une quelconque des revendications 10 à 11, **caractérisé en ce que** la deuxième étape (2000) de traitement comprend en outre une étape de formage (2100) de la diode électroluminescente organique flexible (6 ; 106 ; 206) selon la deuxième forme prédéterminée.

13. Procédé de mise en forme selon la revendication 12, **caractérisé en ce que** l'étape de formage (2100) intervient avant l'étape d'application du vernis (2200).

14. Procédé de mise en forme selon la revendication 12, **caractérisé en ce que** l'étape de formage (2100) intervient après l'étape d'application (2200) du vernis.

15. Procédé de mise en forme selon l'une quelconque des revendications 10 à 14, **caractérisé en ce que** l'étape d'application (2200) du vernis est une étape de pulvérisation de vernis sur ladite au moins portion (20 ; 120 ; 220', 220") de la diode électroluminescente organique flexible (6 ; 106 ; 206).
